# EUROPEAN PATENT SPECIFICATION

(11) **EP 2 590 777 B1**
(45) Date of publication and mention of the grant of the patent: **17.09.2014**
(21) Application number: 11745709.3
(22) Date of filing: 04.07.2011
(51) Int. Cl.: B23K 26/067, B23K 26/06, H01L 31/18, G02B 26/08, G02B 27/10

(54) **LASER PROCESSING WITH MULTIPLE BEAMS AND RESPECTIVE SUITABLE LASER OPTICS HEAD**
LASERVERARBEITUNG MIT MEHREREN STRAHLEN UND ZUGEHÖRIGEM GEEIGNETEM LASEROPTIKKOPF
TRAITEMENT AU LASER AVEC FAISCEAUX MULTIPLES ET TÊTE OPTIQUE À LASER APPROPRIÉE RESPECTIVE

(30) Priority: 17.12.2010 DE 202010013161 U; 08.07.2010 US 362454 P
(43) Date of publication of application: 15.05.2013
(73) Proprietor: TEL Solar AG, 9477 Trübbach (CH)
(72) Inventor: BOOTH, Heather, CH-7323 Wangs (CH); CASHMORE, Julian, CH-7323 Wangs (CH)
(74) Representative: Michalski Hüttermann & Partner Patentanwälte mbB
(86) International application number: PCT/EP2011/061253
(87) International publication number: WO 2012/004230

(56) References cited:
- WO-A1-97/48519
- JP-A- 2004 268 144
- US-A- 5 362 940
- US-B1- 6 635 849

## Description

### Technical Field

The invention relates to a laser optics head configured for use in a laser scribing device and to the laser scribing device comprising the laser optics head. The invention further relates to a method for laser processing a surface of a substrate and to a method for manufacturing a thin film solar cell. Furthermore, the invention relates to a use of the laser scribing device for segmenting the substrate into a plurality of segments.

### Background Art

The use of lasers for scribing thin layer solar cell segments by creating grooves has been well known for many years and is described, for example, in US 4292092 A and JP 59172274 A (US 1985/4542578 A).
WO 97/48519 A1 describes a low power laser, a beam expander, a specially designed phase plate, a prism to deflect the beam, a lens to transmit the diffraction pattern to the far field, a mechanical means to rotate the pattern and a trigger system to fire the laser when sections of the pattern are precisely aligned.
JP2004268144 describes a laser beam machining device which divides a single laser beam into a plurality of laser beams using a diffractive optical element or a combination of a diffractive optical element.
US6635849 describes a laser beam machine having a laser oscillator, for generating a laser beam, a light path system, including galvano mirrors and an ftheta lens that form a light path along which the laser beam emitted by the laser oscillator is guided to an object; and a diffractive optical element, located along the light path leading from the laser oscillator to the galvano mirrors.
US5362940 describes an apparatus for machining and material processing includes an excimer laser and a Fresnel zone plate array (FZP) positioned parallel to the workpiece, with the distance between the FZP and the workpiece being the focal length of the FZP.

Existing optics head of laser scribing tools known from prior art provide for a variation in the cell segment width by making an adjustment of a mechanical system that positions the optics head in a direction perpendicular to a main groove direction. A calibration procedure is used to compare and correct between a desired position of the segmentation groove and its actual position. This calibration can rely upon an iterative procedure or a 'look-up' correction table. The calibration procedure must be performed separately for each of the laser beams in each of e.g. multiple optics heads, for each of the tools in a production environment that run each of the so-called P1-P2-P3 scribing processes. Further, this calibration procedure must be repeated whenever the cell segment width is changed.

The calibration is necessary so that the tolerance on a segment interconnect 'dead' area is maintained and scribe 'pattern' crossing is avoided. The difficulty of the calibration procedure will increase with the accuracy required for the position of the segmentation grooves and this is itself a function of the required 'dead' area: For example, a 'dead' area area width of 200µm would require calibration accuracy better than 10µm, typically 3µm. It becomes increasingly difficult for such an optics head to be positioned accurately enough to meet the beam position calibration accuracy requirements at 10µm or below.

Typically, more involved and time-consuming calibration procedures are necessary and must be repeated more frequently for achieving such high accuracy. Further, in a production environment the many possible combinations of different tools running each of the P1-P2-P3 processes typically result in an accumulation of the segmentation groove positioning errors such that the safe limit for the 'dead' area for the entire production line has to be set considerably larger than the performance limit for an individual laser scribing tool.

### Disclosure of Invention

It is an object of the invention to provide an optics head configured for use in a laser scribing device that provides for a very accurate and reliable way for scribing thin film solar cells, while minimizing the width of the 'dead' area.

This object is achieved by the independent claims. Advantageous embodiments are given in the dependent claims.

In particular, the present invention provides a laser optics head configured for use in a laser scribing device, comprising a diffractive optical element, a focusing objective and an adjusting means, whereby the diffractive optical element and the focusing objective are arranged spaced apart from each other on one common optical axis, and the adjusting means is configured for rotating the diffractive optical element in a third plane orthogonal to the optical axis.

The diffractive optical element (DOE) is preferably a single, compact optical component that enables a splitting of an incident light beam, e.g. a laser beam, into multiple beams that lie in a specific plane. All of the resulting beams from a single DOE preferably possess nearly the same intensity and are directed at a constant angular interval from each other and centred on the optical axis of the optics head. The multiple beams from the DOE are then incident on the focussing objective that directs and focuses the beams preferably towards a solar cell for processing of a solar cell layer stack. The optical performance of the focussing objective is preferably matched to the specific beam splitting angular interval of the DOE and the distance between the optics head and the solar cell.

Thus, the optics head provides for a preferred possibility for patterning a solar cell into different segments. The focussing objective may comprise any means known from prior art for focusing light, such as, for example, lenses, field lenses, reimaging lenses, strip mirrors and/or further means. In a further embodiment the optics head comprises an expansion telescope optical means for producing a larger diameter of an incident and/or falling-out beam.

Preferably, the DOE and the focusing objective are arranged such way in the common optical axis that an incident beam incident into the DOE is optically transmitted by the focusing objective onto, for example, a substrate and/or a solar cell. The DOE is preferably provided as a phase grating element for splitting the incident beams into a plurality of discrete beams. Preferably, the beam is provided as a laser beam and comprises a substantially Gaussian intensity distribution. The plurality of discrete beams is preferably rotatable around an axis parallel to the beams distribution direction and/or orthogonal to the third plane. Thus, the optics head according to invention provides for creating grooves within a substrate surface, whereby the resulting pitch between adjacent beams can be easily and precisely adjusted by rotating the DOE around the optical axis, i.e. in the third plane orthogonal to optical axis.

It has been found that the optics head according the invention including the DOE can be manufactured in a very compact manner and can be very accurately constructed so that the stability of the beam-splitting from the DOE can be translated into a stability of the properties of the resulting multiple beams, for example, their energy distribution and positioning accuracy allowing for very robust performance with reduced and/or minimized dead area compared to prior art. Furthermore, the optics head according to the invention provides for a very easy ability for adjusting the cell segment width by simple rotation of the DOE about the optical axis and still maintain the stability of the properties and position of the multiple beams. In opposite to prior art, only a single calibration procedure is required in order to correlate the DOE rotation angle to the cell segment width thereby reducing tool set up and adjustment time. The optics head according to the invention is especially advantageous when using for patterning isolation grooves of solar cells. Due to the use of the DOE, an improvement in throughput is achieved, as patterning the isolation grooves using all of the multiple beams with the DOE rotated through an angle close to or equal to either 0° or 90° allows scribing multiple grooves simultaneously, whereby the grooves are patterned in a very controlled and accurate way with close spacing and/or overlap in a single processing pass, preferably while having a substrate motion relative to the optics head. Thus, the invention proposes a advantageous way for beam-splitting that provides for simple variation of the segment width of e.g. a solar cell and allows for rapid production of both segmentation grooves over the entire solar cell and also isolation grooves parallel or perpendicular to the main segmentation groove direction e.g. at the edges of the solar cell. It is a further advantage of the invention that the optics head and/or the laser scribing device allows for a reduction in leakage current of such thin film solar cells.

In a further preferred embodiment of the invention, the adjusting means comprises a motorised stage and/or a stepper motor for rotating the diffractive optical element about the optical axis. In another preferred embodiment, the laser optics head comprises a controller and the controller is configured for positioning the diffractive optical element at a defined angular position of the optical axis. In this context, the adjusting means is preferably configured for positioning the diffractive optical element at an angular position with an accuracy of ≤ 1 mrad, preferably ≤ 0.1 mrad and more preferably ≤ 0.01 mrad. Such embodiments allow for a very precise rotation of the diffractive optical element about the optical axis and thus, in turn, result in a very accurate positioning of the multiple beams on a target, e.g. on a substrate and/or on a solar cell. Preferably, the beam position accuracy, when using the means as described before, is ≤ 10 µm, more preferably ≤ 3 µm. Thus, such embodiment allows for creation of a 'dead' area with a width of only less than 200µm.

In another preferred embodiment of the invention, at least the diffractive optical element and the focusing objective are incorporated in a joint housing and the joint housing comprises a material that is configured for reducing the sensitivity of the joint housing to thermal expansion due to environmental changes. Related thereto it is further preferred that the material comprises a low expansion material, preferably fused silica. All of these measures have the advantage that the accuracy, especially the accuracy over time, of the rotation of the diffractive optical element and/or of the multiple beams generated by the diffractive optical element is further improved, thus result in very accurate laser scribing of a substrate.

In a further embodiment of the invention, the diffractive optical element and the focusing objective are spaced apart from each other ≥ 70 mm and ≤ 150 mm, preferably ≥ 25 mm and ≤ 50 mm. Preferably, the angular interval of the DOE ranges from ≥ 1.5° to ≤ 6,5°, more preferably ≥ 3° to ≤ 5°. A suitable optical diameter for the focussing objective is preferably ≥ 15 mm and ≤ 70 mm, preferably ≥ 25 mm and ≤ 50 mm.

The object of the invention is further addressed by a laser scribing device configured for laser processing a surface of a substrate, comprising a positioning means, a laser optics head as described before and a moving means, whereby the positioning means is configured for arranging the substrate with the surface to be processed in a first plane, the laser optics head is configured for generating multiple laser beams by splitting an incident laser beam such that the multiple laser beams exhibit predetermined constant distances from each other and such that the multiple laser beams are arranged in parallel defining a second plane, the focusing objective is configured for focusing the multiple laser beams onto the substrate for processing parallel grooves in the surface such that the first plane and the second plane form an intersecting line and such that the grooves processed in the surface by the individual laser beams incident on the substrate are spaced apart by a pitch from each other, and the moving means is configured for moving the laser optics head relative to the substrate in a moving direction.

Such laser scribing device provides for a very accurate and reliable scribing of a substrate, preferably of a solar cell. The substrate may be any substrate known the person skilled in the art. More preferably the substrate is provided within a solar cell, e.g. a thin film solar cell. Such thin-film solar cells usually comprise a glass substrate on top of which a transparent or semi-transparent electrode layer is deposited, followed by a photoelectric conversion semiconductor formed of a thin amorphous and/or microcrystalline silicon film exhibiting a PIN or NIP structure (N = negatively doped silicon, I = intrinsic silicon, P = positively doped silicon), and a back electrode layer. The back electrode may again comprise a transparent conductive layer plus a reflector layer, a conductive and reflective metal layer or a technical equivalent. The photoelectric conversion semiconductor may be formed as single-, tandem- or multiple junction; each junction again exhibiting a PIN or NIP structure. Thus, the electrode layer comprises the surface to be processed by the laser scribing device.

The glass substrate can be any glass substrate known to the skilled person that is suitable for the manufacturing of thin-film devices. In preferred embodiments the glass is a float glass, security glass and/or quartz glass. Float glass, preferably of larger sizes commonly used for the production of solar cells, is generally produced by delivering molten glass, preferably continuously, to an extended tin bath in a forming chamber. In turn, the molten glass spreads on the tin surface and/or is being drawn by adequate means in at least one direction as a flat continuous glass sheet or layer. By carefully controlling the cooling and pulling process the shape as well as the thickness of the resulting glass sheet can be adjusted.

The thin-films layers according to the present invention can be deposited by various deposition techniques known to the skilled person. In preferred embodiments of the invention the thin-film layers are deposited by a chemical vapor deposition (CVD) or physical vapor deposition (PVD) such as a vacuum sputtering, process. More preferably, the vapour deposition process is a plasma enhanced CVD (PECVD), an atmospheric pressure CVD (APCVD) and/or a metal-organic CVD (MOCVD) deposition process.

The transparent electrode deposited on the glass substrate may comprise any suitable material known in the art. Preferably, it comprises a transparent conductive oxide (TCO), more preferably ZnO or indium tin oxide (ITO). Deposition of the front electrode is preferably accomplished by vacuum/magnetron sputtering, evaporation or CVD, more preferably by LPCVD and most preferably by LPCVD employing diethyl zinc as precursor to form ZnO thin-film layers.

The man skilled in the art may provide any means suitable as a positioning means, preferably a flat table and/or support for arranging the substrate thereon. In an equal manner, the man skilled in the art will provide a laser means for exhibiting the incident laser beam onto the diffractive optical element, as e.g. known from US 4,292,092 and/or US 1985/4542578. Preferably, the laser means operates in an infra-red (IR) region of the spectrum, at the 2nd harmonic wavelength (532nm) and/or at the third harmonic wavelength (355nm), the laser means is pulsed with pulse lengths in the range of 0.01 to 50 nanoseconds and operates at a pulse repetition frequency in the range of a 1 kHz to 40MHz, preferably at 40MHz. The grooves processed in the substrate by the laser scribing device can be, for example, the so-called P1, P2 and/or P3 patterns, as well as a single laser scribe pattern P4 for edge and/or transverse isolation purposes. The moving means preferably comprises a conveyer and/or belt, and is adapted for moving the substrate at a constant speed, whereby the moving direction is preferably parallel to the groove direction processed. In another preferred embodiment the moving means is configured for moving the optics head such that the substrate is laser scribed in a plurality of passes.

Therefore, according to the invention, it is preferred that the multiple laser beams split respectively created by the diffractive optical element are used for creating grooves in the substrate, whereby the individual laser beams are distant to each other by a predetermined distance, which is dependent on an angular interval of the diffractive optical element, while the grooves created in the substrate are distant to each other by a pitch. As the adjusting means is configured for rotating the diffractive optical element, the size of the pitch is variable as it is preferably related to the angular position at which the diffractive optical element is rotated. In this context, according to a further preferred embodiment, the adjusting means is configured for adjusting the pitch of the grooves by changing the angle between the moving direction and the intersecting line. This means that the size of the pitch is adjustable by rotating the diffractive optical element, thereby changing the angle between the moving direction and the intersecting line formed by the first plane and by the second plane. Preferably, the moving direction equals the groove direction. More preferably, the pitch, i.e. the scribe distance, is the closest distance between two adjacent grooves, measured orthogonal to each of the adjacent grooves.

In a further preferred embodiment, the angle is ≥ 0° and ≤ 90° and/or the angle is configured such that at least two adjacent grooves overlap at least partly. An overlapping of at least two adjacent grooves results in a high degree of precision for ensuring that, e.g., all material layers of a solar cell are removed in a continuous region. An angle of 0° preferably results in a "single" groove created by all of the multiple laser beams, while an angle of 90° preferably results in a pitch that equals the distance of the laser beams.

In another preferred embodiment of the invention, the second plane is arranged essentially orthogonal to the first plane and/or the optical axis is arranged essentially orthogonal to the first plane. It is further preferred that the laser optics head is configured for generating ≥ 3 and ≤ 9 laser beams, preferably 4 lasers beams, whereby the multiple beams are preferably parallel to each other. In a further embodiment the adjusting means is configured for creating a pitch of ≥ 4 mm and ≤ 10,8 mm, preferably ≥ 5,5 mm and ≤ 8,5 mm, and more preferably ≤ 0,1 mm. It is especially preferred that the laser optics head is configured for achieving a groove positioning accuracy of ≤ 10 µm, preferably ≤ 3 µm. In another embodiment, the multiple laser beams are configured for processing grooves into a thin film material deposited on the surface. The thin film material may comprise an amorphous and/or microcrystalline silicon film having a PIN, or NIP, junction structure arranged in parallel to the thin film surface. The PIN/NIP structures may be sandwiched between transparent film electrodes, which may continuously extend in each of said plurality of regions on one main surface of the substrate, e.g. a light transmissive substrate or superstrate.

The object of the invention is further achieved by a method for laser processing a surface of a substrate, comprising the steps of:
(a) Arranging the substrate with the surface to be processed in a first plane,
(b) Generating multiple laser beams by splitting a beam of laser light by means of a diffractive optical element such that the multiple laser beams exhibit predetermined constant distances from each other and such that the multiple laser beams are arranged in parallel defining a second plane,
(c) Focusing the multiple laser beams onto the substrate for processing parallel grooves in the surface such that the first plane and the second plane form an intersecting line and such that the grooves to be processed in the surface by the individual laser beams incident on the substrate are spaced apart by a pitch from each other with the pitch adjustable by changing the angle between the desired or intended moving direction and the intersecting line, and
(d) Moving the multiple laser beams relative to the substrate in a moving direction.

In a further preferred embodiment, the second plane is arranged essentially orthogonal to the first plane. Preferably, changing the angle between the moving direction and the intersecting line is being effected by rotating the diffractive optical element. It is further preferred that rotating the diffractive optical element is effected by a motion stage allowing for a rotation about an optical axis on which the diffractive optical element and a focusing objective for focusing the multiple laser beams are arranged spaced apart from each other. In another embodiment, the diffractive optical element is rotated in a third plane and the third plane is essentially orthogonal to the incident single laser beam and/or to the second plane. In a further embodiment, the method comprises the step of calibrating the angle between the moving direction and the intersecting line. In a further embodiment, the angle is ≥ 0° and ≤ 90° and/or the angle is configured such that at least two adjacent grooves overlap at least partially. In a specially preferred embodiment, step (e) is alternatively performed with an angle configured for creating at least partially overlapping grooves. In a further preferred embodiment, the diffractive optical element is configured for generating ≥ 3 and ≤ 9 laser beams, preferably 4 lasers beams. Preferably, the angle between the moving direction and the intersecting line is adjusted such that the pitch is ≥ 4 mm and ≤ 10,8 mm, preferably ≥ 5,5 mm and ≤ 8,5 mm, and more preferably ≤ 0,1 mm. In a further embodiment, the diffractive optical element is configured for focusing the multiple laser beams on the substrate thereby achieving a groove positioning accuracy of ≤ 10 µm.

Further embodiments and/or advantages of the method for laser processing a surface of a substrate will be derived by the man skilled in the art from the laser optics head and/or laser scribing device as described before.

The object of the invention is further achieved by a method for manufacturing a thin film solar cell comprising the steps of:
(1) Depositing a thin film material on a substrate, and
(2) Laser processing the substrate with a method as described before, whereby the thin film material comprises the surface to be processed, or
(2') Laser processing the substrate with a laser scribing device as described before, whereby the thin film material comprises the surface to be processed.

In further preferred embodiment, step (2) or step (2') comprises laser processing of at least 20% of the surface area of the substrate. Preferably, the surface is processed in ribbons running in the perpendicular direction to the segmentation grooves. Such steps are preferably repeatedly carried out, e.g. in several thousand overlapping transverse grooves to effectively increase the light transmission of the solar cell.

The object of the invention is further achieved by a use of a laser scribing device as described before for segmenting the substrate into a plurality of segments, comprising a thin film solar cell, the thin film solar cell comprises the substrate and a thin film material deposited on the substrate and the thin film material comprises the surface to be processed by the laser scribing device.

### Brief Description of Drawings

These and other aspects of the invention will be apparent from and elucidated with reference to the embodiments described hereinafter.

In the drawings:
Fig. 1 shows a principle of a thin film solar cell including scribe lines to partition the solar cell according to prior art,
Fig. 2 shows an optical relationship between a diffractive optical element and a focussing objective of a laser optics head according to a preferred embodiment of the invention,
Fig. 3A to C show an optics head according to a preferred embodiment of the invention in side or cross section views, and
Fig. 4A, B and Fig. 5A, B show the context of pitch of adjacent laser beams and rotation of the diffractive optical element generating a plurality of laser beams for various applications by using the laser optics head according to the preferred embodiment of the invention.

### Detailed Description of Drawings

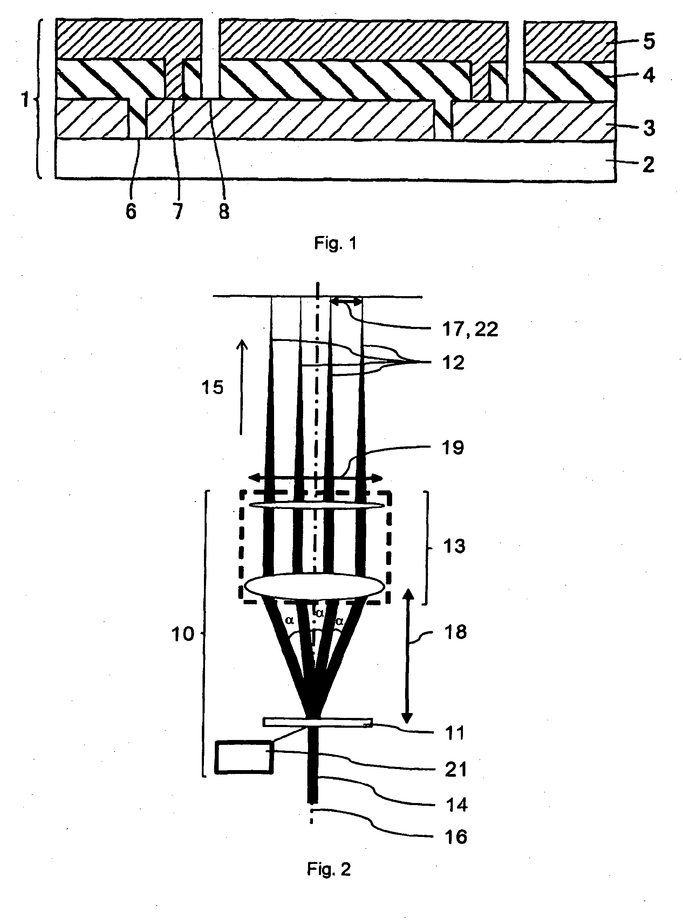

Fig. 1 is a schematic cross section of a portion of a conventional thin film solar cell 1 according to prior art. On a transparent insulator substrate 2 a transparent front electrode layer 3 is being arranged, a photoelectric conversion semiconductor 4 is formed on the transparent front electrode layer 3 and a further transparent back electrode layer 5 is formed on the photoelectric conversion semiconductor 4. The photoelectric conversion semiconductor 4 comprises a thin amorphous and/or a microcrystalline silicon film stack.

Fig. 1 further shows grooves 6, 7 and 8. The purpose of this structuring is to establish a monolithic photovoltaic module composed of a number of solar cell segments electrically connected in series. The transparent electrode layer 3 is therefore divided by the first isolation groove 6, which determines the cell segment width. The photoelectric conversion semiconductor layer 4 is filling that groove, when the overall layer stack is being built up in the order: layer 3 - groove 6 - layer 4 - groove 7 - layer 5 - groove 8 during the manufacturing process. The groove 7, filled with material from the transparent back electrode layer 5, permits the electrical contact between the adjacent cells 1. In fact, the back electrode 5 of one cell 1 contacts the front electrode 3 of the adjacent cell 1. The back surface electrode layer 5 and the photoelectric conversion semiconductor 4 are finally divided by the second isolation groove 8. This structuring process is achieved preferably by employing a laser light or the like.

The thin film solar cell 1 can be fabricated for example as follows: Initially over a transparent insulator substrate 2, a transparent electrode layer 3 is deposited e.g. by means of LPCVD, i.e. low pressure CVD. This transparent electrode layer 3, also called transparent conductive oxide TCO, comprising e.g. ZnO, SnO2 and/or Indium tin oxide ITO, is thereafter laser-scribed to remove a portion of said transparent electrode layer 3 to form a first isolation groove 6 dividing the transparent electrode layer 3 into a plurality of thus isolated, adjacent layers.

Subsequently, over this patterned transparent electrode layer 3, plasma-enhanced CVD is employed to deposit a photoelectric conversion layer stack 4. The layer stack 4 comprises at least one p-doped layer, an intrinsic i-layer and an n-doped layer of e.g. thin amorphous silicon. This operation can be repeated in order to form a multi junction amorphous silicon thin film solar cell 1. Thus p-i-n junctions can be formed from microcrystalline materials or a mix from amorphous and microcrystalline materials in order to establish said photoelectric conversion layer 4.

The photoelectric conversion semiconductor layer 4 is then laser-scribed in order to remove a portion of the photoelectric conversion semiconductor layer 4 to form a groove 7 dividing the photoelectric conversion semiconductor layer 4 into a plurality of such isolated layers 4.

Subsequently, the back surface electrode layer 5 is deposited to fill the groove 7 and thereby resulting in a contact line and also to cover photoelectric conversion semiconductor layer 4. This back surface electrode layer 5 can again be a transparent conductive oxide TCO, e.g. ZnO, SnO2, Indium tin oxide ITO, or a metallic layer, e.g. aluminum, or a combination of such layers.

Finally, the photoelectric conversion semiconductor layer 4 and back-surface electrode layer 5 are laser-scribed forming the second isolation groove 8 that divides the photoelectric conversion semiconductor layer 4 into a plurality of photoactive layers 4, or segments, electrically connected in series. The thin film solar cell 1 shown in Fig. 1 is thus fabricated.

The invention discloses separating the TCO layer 3 into a plurality of electrically isolated regions by laser scribing of grooves 6 at typically 5-10 mm intervals across the solar cell 1 and extending its entire length. After deposition, the photoelectric conversion semiconductor layer 4 is subsequently scribed by a laser. This requires the grooves 7 scribed in this layer to be parallel to the initial grooves in the TCO layer 3 to typically within 5-30µm along their entire length and as close as possible to the initial grooves 6 with a typical spacing of between 10 and 150µm.

After deposition of the back surface electrode layer 5, a laser is used to form the second isolation groove 8 that divides the back surface electrode layer 5 and the photoelectric conversion semiconductor layer 4 at the same time to complete electrical series interconnection of the segments. The grooves 8 are scribed to be parallel to the initial grooves 6 in the TCO layer 3 to typically within 5-30 µm along their entire length and as close as possible to the grooves 7 in the photoelectric conversion semiconductor layer with a typical spacing of between 10 and 150µm.

The resulting solar cell 1 exhibiting a serial interconnection of solar cell segments allows reduction of the leakage current of such thin film solar cells 1 and the voltage generated by the whole panel is given by the product of the potential formed within each cell and the number of cells. Typically, panels of 1.4m² are divided up into 50-200 cells so that overall panel output voltages are in the 30-200V range.

In addition to those materials described in US 4,292,092 and JP 59172274 (US 1985/4542578), many other materials can be used to make thin film solar cells 1. Other equally effective devices are made with a photoelectric conversion semiconductor layer 4 based on Cadmium Telluride (CdTe), Copper-Indium-diselenide (CIS), Copper-Indium-Gallium-diselenide (CIGS) and crystalline silicon on glass (CSG) amongst others. Lasers are typically used to scribe grooves 6, 7, 8 in some or all of the layers 3, 4, 5 to create a plurality of solar cells 1 with serial interconnections in these devices.

The laser beams that are used to scribe the grooves 6, 7 and 8 in the individual layers 3, 4, 5 are sometimes applied from the coated side of the glass sheet but can also be applied from the opposite side in which case the beams pass through the glass before interacting with the film. The lasers used generally operate in the infra-red (IR) region of the spectrum but lasers operating at the 2nd harmonic wavelength, e.g. at 532nm, and third harmonic wavelength, e.g. at 355nm, can also be used. The lasers are generally pulsed with pulse lengths in the range of 0.01 to 50 nanoseconds and operate at pulse repetition frequencies in the range of a 1 kHz to 1 MHz, but may be as high as 40MHz. The laser beams are directed onto the layer stack 3, 4, 5 to be processed in prior art with an opto-mechanical system generally known as an optics head that is designed to provide the required spatial intensity distribution necessary for effective material processing.

Thin film solar cells can also be made on non-transparent substrates such as metal sheets. In this case, irradiation through the substrate 2 is not possible so all scribing processes require beams incident from the coated side. In some other cases solar panels are fabricated on flexible substrates 2 such as thin metal or polymer sheets. In the former case irradiation from only the coated side is possible. In the latter case irradiation from the coated side or through the substrate 2 are both possible.

The placement of the grooves 6 on the solar cell 1 determines the segment width. The choice of segment width, in combination with the cell size, is based on the desired electrical characteristics of the solar cells 1, e.g wider segments give an increased leakage current I_{SC} (sc=short circuit), narrower, i.e. more, segments give an increased open circuit voltage V_{OC}. Other considerations may impact the segmentation groove 6, 7, 8 width including: cell layout configuration of either series connected, parallel connected or other combination of connection of cells, optimisation of current losses in the cell influenced by the front 3 and back 5 electrode layer materials sheet resistances.

To produce an effective serial connection between segments of the solar cell 1, each groove 6, also known as pattern 1 or P1, should be structured together with a groove 7, also known as pattern 2 or P2, and then a groove 8, also known as pattern 3 or P3, should be structured as described in prior art. The area of the cell 1 contained within the narrow region defined by the outermost edge of the P1 groove 6 to the outermost edge of the adjacent P3 groove 7 is not able to contribute to the collection of the photovoltaic current and is effectively lost, or 'dead', area 9. This area is replicated for each segment in the cell 1 and can amount to several percent of the available active area of the cell 1. It is therefore essential to minimise this dead area 9 to obtain the maximum cell efficiency. The dead area can be minimised by reducing the separation of the P1 to P2 grooves 6, 7 and the separation of the P2 to P3 grooves 7, 8. However, the interconnection between segments will fail if any of the patterns 'cross': That is if the groove sequence of P1-P2-P3 is disrupted and this will degrade the solar cell 1 power. A reduction in the groove separation requires accurate laser beam placement at each process step so that the 'dead' area is reduced but groove pattern 'crossing' is avoided.

A laser scribing tool for each process P1-P2-P3 is set up to position the segmentation grooves 6, 7, 8 at the correct separation in advance of starting the scribing process. This typically relies in prior art upon a calibration procedure that compares the desired groove 6, 7, 8 position determined by the optics head 10 position with the actual groove 6, 7, 8 position and then to correct the optics head 10 position as necessary. This step typically involves patterning alignment features or fiducials on the solar cell 1 and can be performed at a frequency that can vary from only once, when the choice of segment width is first made, up to every time that a solar cell substrate 2 is produced through the tool. Obviously, in prior art, a calibration procedure must be performed for each laser beam and/or each optics head and the more frequently the calibration must be performed, the larger the overall cycle time for the laser process step becomes. The frequency of the calibration will increase if the accuracy and stability of the alignment feature measurement system or the optics head positioning system is poor compared to the accuracy required for the position of the segmentation grooves 6, 7, 8.

The overall cycle time of the laser process step contributes to the overall throughput for the solar cell fabrication and therefore minimising this time leads to an improvement in the cost of ownership, CoO, of the solar cell 1. Several approaches to reducing laser process cycle time involve operating multiple optics heads t10 hat direct multiple laser beams 12 towards the solar cell 1 to produce several segmentation grooves 6, 7, 8 in parallel, at the same time, over the length of the solar cell 1. In this way fewer passes of the optics heads 10 or the substrate 2 are required to completely segment the solar cell 1. As already described, each laser beam and each optics head 10 of the prior art systems must be calibrated so that the segmentation groove 6, 7, 8 is accurately located on the solar cell 1.

Edge isolation grooves running parallel, and positioned close to the four edges of the solar cell 1 are necessary so that current short circuits are not produced between one end of a segment and another segment or with the contacting areas on the solar cell 1 used for current collection. Short circuits, i.e. shunts, can reduce the power performance of the solar cell 1.

Transverse isolation grooves running perpendicular to the segmentation grooves, which may be distributed across the solar cell 1, are typically used to limit the maximum current that can flow in a region of the cell 1 where illumination by sunlight is obscured and so prevent damage to that area of the cell and degradation of the performance of the entire solar cell 1.

Both types of edge and transverse isolation grooves can be formed with either a single laser scribe process, pattern 4 or P4, after the solar cell 1 segmentation processes P1-P2-P3 or with a combination of groove scribing as part of the P1 and P3 processes. In both cases the requirement is to remove all the material layers of the solar cell 1 on the substrate 2 and provide a sufficiently high degree of electrical resistance across the isolation grooves.

Typically, several passes of the substrate 2 or optics are used to produce multiple isolation grooves 6, 7, 8 that are very closely spaced or overlapping, in which case the spacing between the centres of adjacent grooves 6, 7, 8 is less than the individual groove widths. Multiple isolation grooves 6, 7, 8 reduce the probability that an isolated shunt, or other failure, in a single groove will result a current short circuit that could degrade cell performance.

However, the greater the number and separation of the isolation grooves 6, 7, 8, the greater the area of the solar cell 1 that is not available for electricity generation. In the typical case of the combination of the P1 and P3 processes to produce isolation grooves 6, 8, it is necessary that the P1 and the subsequent P3 grooves 6, 8 overlap each other to high degree of precision to ensure that all the material layers 3, 4, 5 of the solar cell 1 are removed in a continuous region. The placement accuracy of the different scribing processes that can be realistically achieved in a production environment requires multiple, closely spaced or overlapping, sets of P1 and P3 grooves 6, 8 to ensure that the two separate processes are overlaid on the solar cell 1 and effective isolation grooves are produced.

The number of laser-scribed grooves 6, 7, 8 required for creating the isolation grooves and the condition that they must be closely spaced impacts considerably on the processing time and can be a significant portion of the overall cycle time for the laser process step.

A common characteristic of all these thin film solar cell devices is that multiple grooves 6, 7, 8, each up to one or more metres in length, have to be scribed in order to create the plurality of segments across the panel. Hence total laser groove lengths per layer of up to or in excess of 100m are required. This laser grooving must be realised by an industrial laser scribing tool in an acceptable panel process cycle time. This is generally less than 2 minutes and therefore laser scribing rates up to many metres per second are required.

In a laser scribing tool the segmentation of solar cells 1 using laser irradiation relies upon relative movement of the optics head 10, which directs a laser beam towards the solar cell 1, and the substrate 2, either one can be fixed or moving with respect to the machine frame of reference, whilst the laser beam is incident on the solar cell 1, or substrate 2, so that a continuous groove 6, 7, 8 is formed in the solar cell layers.

One approach in prior art has been to use a single beam to scribe all the lines but cause the beam to move at high speed using a galvanometer driven mirror scanner system. US Patent Application Publication No. US2003/0209527A1 describes such a case. A scanner system is used to move the laser beam across the full width of a 600mm wide panel at speeds of up to 4 metres/sec while the panel is moved in the orthogonal direction past the scanner unit. This prior art has the drawback that to cover the full width of the panel a scanner lens with a large scan field has to be used. This usually means that the lens has a relatively long focal length. It is also often necessary to use a scanner system with a third axis to dynamically adjust the expansion of the beam size during each scan in order to maintain focus over the full panel width.

This adds complexity to the control system. The long focal length of the scan lens required leads to limitations to the minimum size of the focal spot that can be created and hence the groove width that can be made is not as narrow as desired. It also leads to difficulties placing the grooves accurately as the positioning errors associated with scanner systems scale with the lens focal length. Both of these can be severe problems as ideal grooves 6, 7, 8 should be as narrow in width as possible and successive grooves should be as close together as possible to minimise the 'dead' area between the three grooves 6, 7, 8. In addition, due to the limitations of the optical system required to achieve such a line scan, this approach is normally limited to scribing the panels parallel to the shorter dimension of the panel, typically up to a length of 600mm. It is not possible with such a system to create grooves 6, 7, 8 parallel to the long axis of the panel.

In some prior art cases the tools have stationary optics during the line scribing which means the panel has to be moved very rapidly. To avoid excessive panel speed multiple optical systems are often used to generate parallel laser beams for processing the grooves 6, 7, 8. As an example of this a panel with dimension of about 1.1 m x 1.3m requiring 100 separate grooves 6, 7, 8 can be processed with 8 parallel laser beams in under 60 seconds with the panel moving at a maximum speed of less than 300mm/sec. The multiple beam approach has been realised in a variety of laser tool architectures.

Another approach in prior art is to use an optical system consisting of a single laser of relatively low power e.g. less than 5W at 355nm or 532nm, or less than 10W at 1064nm. This low power laser is coupled to a single optical head delivering a laser beam to the work-piece. A plurality of such optical systems is fitted in the tool to increase the net processing speed. Such a system is described in German Patent Application No. DE 10 2006 033 296.2 and US Patent Application Publication No. US 2008/0263877.

This approach has the disadvantage that either the panel or all of the optical systems need to be stepped in the direction perpendicular to the groove direction to cover the entire panel with grooves 6, 7, 8. This means that the positioning system must be very accurate, or that a calibration of each laser beam position must be performed across all positions of the optical heads 10 to reach the necessary accuracy for the module requirements. The cost of the system with multiple laser sources is typically high and can negatively impact the cost of ownership of the solar cell 1. In addition, there are a larger number of laser sources which require regular servicing and collectively have a greater chance of failure thus resulting in reduced uptime and increased overall cost of ownership.

A further approach in prior art is to use an optical system consisting of a single laser of relatively high power e.g. more than 10W at 355nm, or more than 5W at 532nm, or more than 20W at 1064nm. The high power laser beam is then split by polarisation division or by intensity division to deliver multiple laser beams to a plurality, typically 2-4, optical heads 10. In this case a number of such optical systems could be fitted to a single laser tool. Such a system is described in German Patent Application No. DE 10 2006 033 296.2. This tool architecture has the advantage of requiring only one, or typically two, laser sources per tool reducing the downtime requirements for maintenance, scheduled and unscheduled.

However, the alignment, polarisation control and beam power balancing in the optical system is complex and can be time consuming to realise in practice. Any changes in the laser beam properties in the optical system such as beam pointing, power and intensity profile can result in significant differences between the individual beams at the processing area on the panel. Power variations and profile variations between beams can affect the groove 6, 7, 8 quality, and position variations between beams can result in a need for frequent calibration operations. The result is a reduced uptime of the tool due to the need for frequent calibration routines and alignment checks to be performed.

All of the prior art laser tools described above have the beams typically positioned in one or more linear arrays in the tool with the linear axis perpendicular to the groove direction. In order to laser scribe the same panel in two orthogonal directions on the tool, for example to create the edge isolation and transverse isolation grooves 6, 7, 8, it is possible to use only one laser beam for the full pass of the panel, or to rotate the panel in the tool to perform the orthogonal grooves 6, 7, 8. In the first case this single beam processing is inefficient and can often be a significant contributing factor to tool cycle time. In the second case the panel rotation process adds to the cycle time of the tool. Typically, the panel dimensions are asymmetric and the tool architecture can often make it impossible to rotate the panel due to lack of space to accommodate the long axis of the panel in the orthogonal direction to the main groove direction.

A laser scribing tool equipped with multiple optics heads 10 may be configured so that multiple laser beams can be directed towards the solar cell 1 in an arrangement with the line of multiple laser beams perpendicular to the segmentation groove direction so that several segmentation grooves 6, 7, 8 can be produced in parallel, at the same time, over the length of the solar cell 1.

However, this arrangement is not as suitable for processing of the edge isolation grooves and particularly the transverse isolation grooves that run in the perpendicular direction to the main segmentation grooves 6, 7, 8. The requirements for high precision in the placement of the multiple overlapping or closely spaced edge isolation or transverse isolation grooves are in the direction parallel to the segmentation grooves 6, 7, 8, whereas accurate placement of the segmentation grooves requires accurate positioning in the direction perpendicular to the segmentation grooves 6, 7, 8. The complexity required to have accurate groove placement in both directions for an optics head 10 based on a mechanical system is significant. Typically, the simpler approach that is adopted is to shut off, mechanically or optically, all but one of the multiple optics heads 10 and laser beams so that there is one isolation groove 6, 7, 8 processed at a time. Without the multiple parallel beam processing, the time required to completely pattern the isolation grooves 6, 7, 8 becomes a significant fraction of the overall cycle time for the laser processing and impacts CoO for the module.

An approach that allows for easier adjustment of the cell segment width, with less time-consuming calibration of the groove position and for multiple patterning of both segmentation and isolation grooves would have considerable benefit on both laser process time and therefore CoO of the solar cell fabrication.

The solution according to the invention employs a feature of an optics head 10 that uses a diffractive optical element (DOE) 11 to provide multiple laser beams 12. In the optics head 10 the DOE 11 is combined with a focussing objective 13. The DOE 11 is a single, compact optical component that enables a splitting of an incident laser beam 14 into multiple beams 12 that lie in a specific second plane 15. All of the resulting beams 12 from a single DOE 11 possess nearly the same intensity and are directed at constant angular intervals α from each other and centred on an optical axis 16 of the optics head 10.

The multiple beams 12 from the DOE 11 are then incident on the focussing objective 13 that directs and focuses the laser beams 12 towards the solar cell 1 for processing of the solar cell layer stack 3, 4, 5. The optical performance of the focussing objective 13 is matched to the specific beam splitting angular interval α of the DOE 11 and the distance between the optics head 10 and the solar cell substrate 2. The resulting cell segment width 17 patterned with the DOE 11 optics head 10 is determined by the angular splitting α of the DOE 11 and a separation 18 between the optics head 10 and DOE 11.

A schematic showing the path of the incident laser beam 14 through a possible embodiment of an optics head 10 and the resulting multiple focussed laser beams 12 used for the solar cell 1 processing is shown in Fig. 2. In this example, the DOE 11 is configured such that the single incident beam 14 is split into four separate beams 12 that are then focussed on to the solar cell layer stack 3, 4, 5 allowing for simultaneous processing of four segmentation grooves 6, 7, 8 in the solar cell 1. By rotating the DOE 11 in an optical laser head 10 arrangement the resulting pitch 17, i.e. the cell segment width 17, between adjacent laser beams 12 in the direction perpendicular to the main groove direction 24 can be adjusted to match various processing needs and thus provide for flexibility in the laser treatment of substrates 2 e.g. the scribing of solar cell layer stacks 3, 4, 5.

In an embodiment according to the invention embodiment the typical cell segment width 17, the pitch 17, is in the range of 5.5 to 8.5mm but could be as large as 10.8mm. As it is shown in Fig. 2, this is determined by the DOE 11 to focussing objective 13 separation 18 and the angular splitting interval α of the DOE 11, however, it is typically limited by the maximum optical diameter 19 of the focussing objective 13. The angular interval α of the DOE 11 for this application can typically range from 1.5° to 5° but could be as large as 6.5°, whilst the separation 18 between the DOE 11 and focussing objective 13 is typically in the range of 70 to 150mm. A suitable optical diameter 19 for the focussing objective 13 would lie in the range of 25 to 50mm.

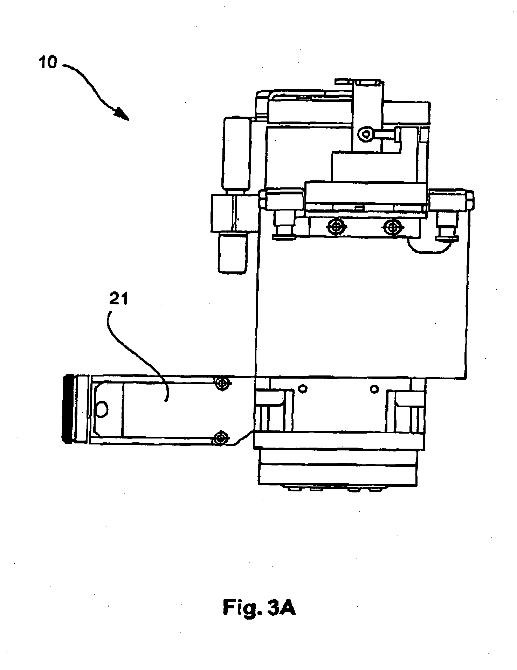

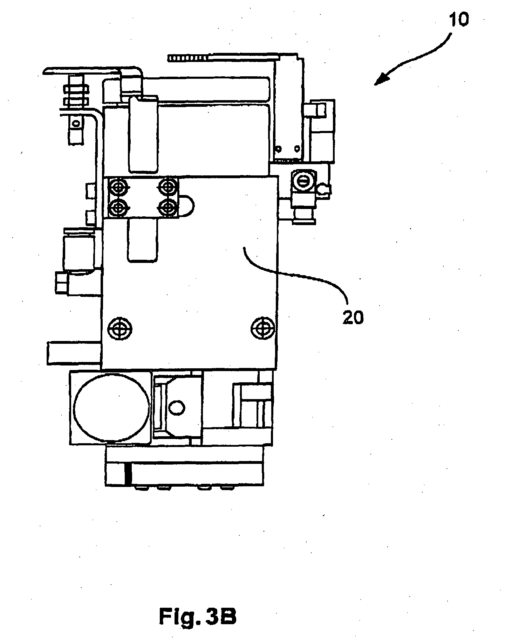

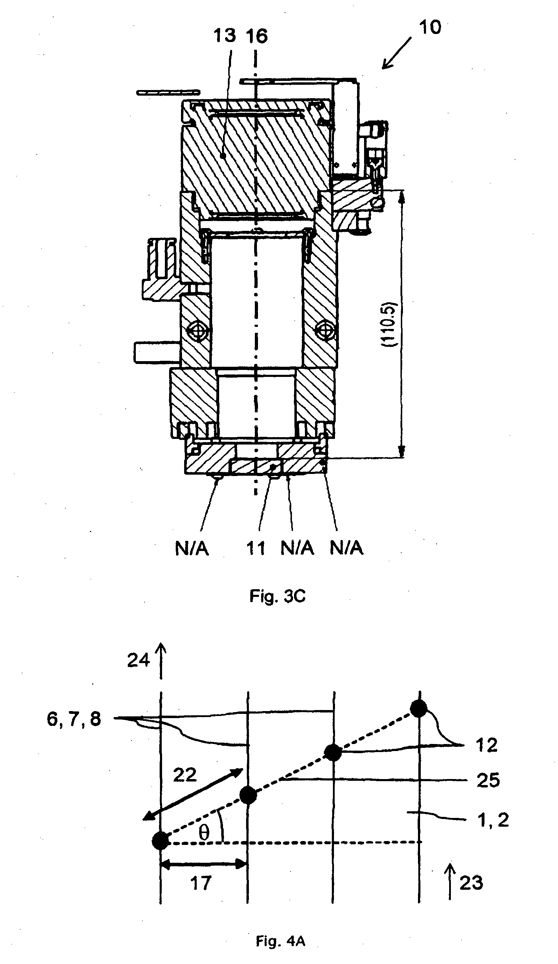

Mechanical drawing layouts of a possible embodiment of the optics head 10 are shown in Fig. 3A to 3C. It comprises a central mounting block 20 to which all other components are attached, including the focussing objective 13, the DOE 11 and an adjusting means 21, e.g. a motorised stage 21, for rotation of the DOE 11 about the optical axis 16. All additional features shown in the drawings are necessary for the correct functioning of the optics head 10 when integrated into a laser scribing tool, including: Alignment and positioning systems, beam shuttering, and setup and maintenance access. However, these are not the subject of the present invention and thus not described further here, but are applicable and/or obvious for the man skilled in the art. The entire assembly is held on a separate set of translation and elevation stages that allow for precise positioning of the optics head 10 and the multiple laser beams 12 used for processing of the solar cell layer stack 3, 4, 5.

This compact arrangement allows for a low mass assembly that can be moved at high speeds if required for rapid processing and can be designed for high position stability. In addition, only small lengths of material are present along the optical axis 16 so the assembly is more tolerant of thermal expansion due to environmental changes. One optics head 10 can be used through the proper choice of DOE 11 and focussing objective 13 to provide anywhere from 3 to 7 multiple beams 12.

The accuracy of the angular splitting interval α in the multiple beams 12 following the DOE 11 is typically less than 0.1mrad and in combination with an optics head 10 to DOE 11 separation 18 of the order of 100mm results in a segmentation groove 6, 7, 8 positioning accuracy of better than 10µm. However, the stability of the beam spacing is much improved compared to other forms of conventional beam splitting optics since for the DOE 11 system it is dependent on the periodic fine scale features that are integral to the DOE 11 structure.

The DOE 11 is fabricated out of a suitable optical material, such as fused silica, which is exceptionally stable over time and against changes in the environmental conditions e.g. temperature. The DOE 11 optics head 10 is a compact arrangement for providing multiple segmentation grooves 6, 7, 8 from a single optical unit with a high degree of positioning accuracy and excellent stability.

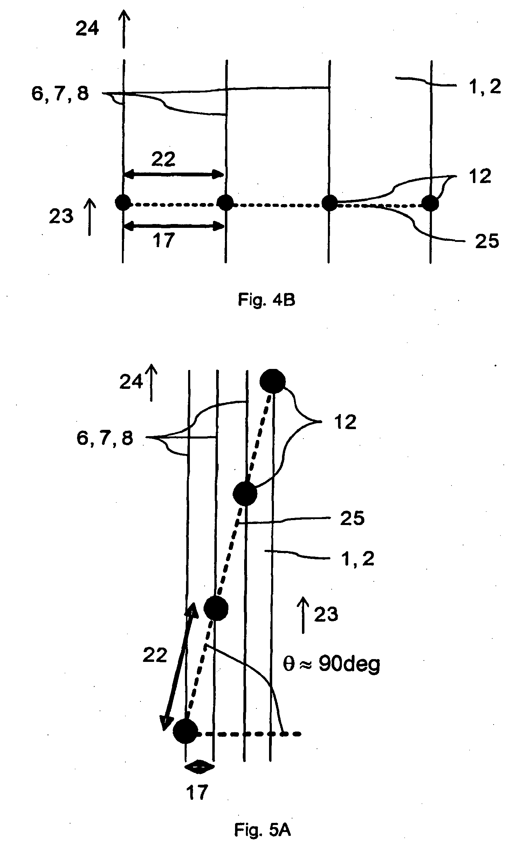

In this invention a novel use of the DOE 11 optics head 10 allows one to overcome the complexities of repeated recalibration of optics heads 10 based on mechanical positioning when changing cell segment widths 17, or calibrations that may be required due to other variations and drifts in such a positioning system. This novel use of the DOE 11 optics head 10 also enables a laser scribing tool to pattern the edge isolation and transverse isolation grooves 6, 7, 8 maintaining the use of the multiple beams 12 and therefore reducing the overall laser process cycle time. These features are described further in the diagrams in Fig. 4A and B.

As already described, the DOE 11 provides regularly angularly spaced multiple beams 12 that lie in a specific plane 15. With a view on Fig. 4A and B, a separation 22 of the multiple beams 12 at the first processing plane 23 determines the cell segment width 17. The orientation of this plane 22 corresponds with the orientation of the periodic fine scale features in the structure of the DOE 11.

By rotating the DOE 11 about the optical axis 16 of the optics head 10 it is possible to rotate the plane 17 that the split multiple beams 12 lie within. When these multiple beams 12 are relayed through the focussing objective 13 and one considers the spacing or separation 22 of these beams 12 in a direction perpendicular to the segmentation groove direction 24 that is at the angle θ to the line drawn between the intersection 25 of the multiple beams 12 and the solar cell 1 substrate 2, the effective cell segment width 17 that would be scribed by these multiple beams 12 will vary directly with the product of the cosine of the angle θ and the separation 22 of the multiple beams 12.

In practice, the rotation of the DOE 11 about the optical axis 16 of the optics head 10 can be accomplished with a high accuracy motion stage 21 that mounts the DOE 11 and this then allows precise rotation about the optical axis 16 and through an angle θ of motion of at least 90° and with an accuracy that is typically better than 10µm. In this way it is possible to have all the multiple laser beams 12 at the solar cell 1 in a line parallel or perpendicular to the segmentation groove direction 24, or at any angles between these two limits.

The maximum segmentation groove separation, i.e. the maximum cell segment width 17, is achieved with a value of θ = 0°, i.e. the beam splitting direction is perpendicular to the groove direction 24. The robust nature of the optical beam splitting provided by the DOE 11, combined with an accurate rotation stage 21, ensures that only a one-time calibration of the cell segment width 17 versus the DOE 11 rotation angle θ is required for each optics head 10 and is not required for each split beam.

Once the calibration has been performed on each optics head 10 in the laser scribing tool, it is then simple to set a constant segment width 17 for continuous production or to make small adjustments to the segment width 17 if necessary to optimise electrical characteristics of the solar cell 1 or to correct for other undesired contributors to segment width 17 variation on a cell-wide basis. The calibration sequence can typically take 10 to 20 seconds to pattern alignment marks on an unused region of the solar cell 1 and then register their positions and apply correction factors to the position of each processing beam. This procedure need only be applied at infrequent intervals during production to confirm that the tool calibration has not drifted, or if desired when the layout is changed to use a different cell segment width.

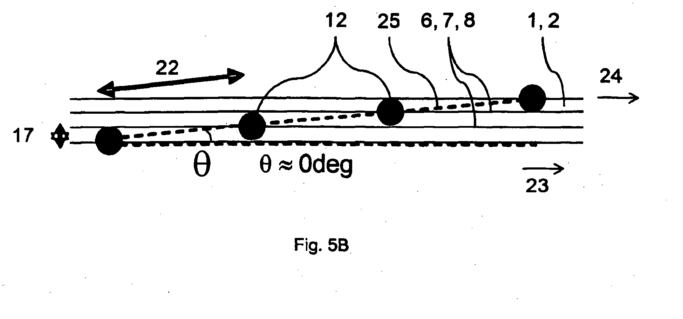

At rotation angles θ approaching either 90° or 0°, as shown in Fig. 5A and B, it is possible to arrange for the separation of the multiple beams 12 in the segmentation groove direction 24, or in the perpendicular direction, to be reduced such that the individual grooves 6, 7, 8 processed by the beams 12 are either very close together or even partially overlap to effectively produce one single wide groove 6, 7, 8. The 'composite' groove 6, 7, 8 benefits from the same features of the DOE 11 beam splitting in terms of a precise and stable control of the overall width 17 with no additional calibration required to set up for such a configuration.

These multiple isolation groove structures can be produced in a single processing pass of the substrate 2 motion relative to the optics head 10. Such a set of 'composite' grooves 6, 7, 8 is suitable for use as edge isolation or transverse isolation grooves 6, 7, 8 since these features typically benefit from the additional isolation provided by the multiple grooves. Typically, in the range of four to nine individual grooves 6, 7, 8 are used to form the edge isolation or transverse isolation grooves 6, 7, 8 and on a full-size solar module there would typically be at least four of each type of the isolation grooves 6, 7, 8. The cycle time required for the laser process step for a conventional laser processing optics head 10, relying upon the use of multiple passes of a single laser beam to pattern the edge and transverse isolation grooves 6, 7, 8, can typically be reduced by 35 to 65 seconds with the novel use of the invention described here.

In addition, in certain applications concerned with Building Integrated Photovoltaics (BIPV) it is advantageous to remove up to 20% of the area of the silicon film in ribbons running in the perpendicular direction to the segmentation grooves 6, 7, 8. This typically requires repeated application of the P3 pattern 8 in several thousand overlapping transverse grooves 6, 7, 8 to effectively increase the light transmission of the module.

In the invention described here, the rotation of the DOE 11 to angles θ close to 90° can allow for simultaneous scribing of multiple overlapping transverse grooves 6, 7, 8 and therefore considerably reduce the laser process cycle time by a factor approximately equal to the number of multiple beams 12 used for the patterning.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: thin film solar cell
- 2: substrate
- 3: front electrode layer
- 4: photoelectric conversion semiconductor
- 5: back electrode layer
- 6: first isolation groove
- 7: groove
- 8: second isolation groove
- 9: dead area
- 10: optics head
- 11: diffractive optical element
- 12: multiple laser beams
- 13: focusing objective
- 14: incident laser beam
- 15: second plane
- 16: optical axis
- 17: pitch
- 18: DOE separation
- 19: diameter
- 20: central mounting block
- 21: adjusting means
- 22: separation
- 23: first plane
- 24: segmentation groove direction/moving direction
- 25: intersecting line

## Claims

1. Laser optics head (10) configured for use in a laser scribing device, comprising a diffractive optical element (11), a focusing objective (13) and an adjusting means (21), whereby
the diffractive optical element (11) and the focusing objective (13) are arranged spaced apart from each other on one common optical axis (16),
the adjusting means (21) is configured for rotating the diffractive optical element (11) in a third plane orthogonal to the optical axis (16),
at least the diffractive optical element (11) and the focusing objective (13) are incorporated in a joint housing,
the joint housing comprises a material that is configured for reducing the sensitivity of the joint housing to thermal expansion due to environmental changes,
and
the material comprises fused silica as low expansion material.

2. Laser optics head (10) according to the preceding claim, whereby the adjusting means (21) comprises a motorised stage (21) and/or a stepper motor for rotating the diffractive optical element (11) about the optical axis (16).

3. Laser optics head (10) according to any of the preceding claims, comprising a controller and the controller is configured for positioning the diffractive optical element (11) at a defined angular position (θ) of the optical axis (16).

4. Laser optics head (10) according to any of the preceding claims, whereby the diffractive optical element (11) and the focusing objective (13) are spaced apart from each other (18) ≤ 70 mm and ≤ 150 mm, preferably ≥ 25 mm and ≤ 50 mm.

5. Laser scribing device configured for laser processing a surface of a substrate (2), comprising a positioning means, a laser optics head (10) according to any of the preceding claims and a moving means, whereby
the positioning means is configured for arranging the substrate (2) with the surface to be processed in a first plane (23),
the laser optics head (10) is configured for generating multiple laser beams (12) by splitting an incident laser beam (14) such that the multiple laser beams (12) exhibit predetermined constant distances (22) from each other and such that the multiple laser beams (12) are arranged in parallel defining a second plane (15),
the focusing objective (13) is configured for focusing the multiple laser beams (12) onto the substrate (2) for processing parallel grooves (6, 7, 8) in the surface such that the first plane (23) and the second plane (15) form an intersecting line (25) and such that the grooves (6, 7, 8) processed in the surface by the individual laser beams incident on the substrate (2) are spaced apart by a pitch (17) from each other, and
the moving means is configured for moving the laser optics head (10) relative to the substrate (2) in a moving direction (24).

6. Laser scribing device according to the preceding claim 5, whereby the adjusting means is configured for adjusting the pitch (17) of the grooves (6, 7, 8) by changing the angle (90° - 9) between the moving direction (24) and the intersecting line (25).

7. Laser scribing device according to any of the preceding claims 5 or 6, whereby the angle (θ) is ≥ 0° and ≤ 90° and/or the angle (θ) is configured such that at least two adjacent grooves (6, 7, 8) overlap at least partly.

8. Laser scribing device according to any of the preceding claims 5 to 7, whereby the second plane (15) is arranged essentially orthogonal to the first plane (23) and/or the optical axis (16) is arranged essentially orthogonal to the first plane (23).

9. Laser scribing device according to any of the preceding claims 5 to 8, whereby the laser optics head (10) is configured for generating ≥ 3 and ≤ 9 laser beams (12), preferably 4 lasers beams (12).

10. Laser scribing device according to any of the preceding claims 5 to 9, whereby the multiple laser beams (12) are configured for processing grooves (6, 7, 8) into a thin film material deposited on the surface (2).

11. Method for laser processing a surface of a substrate (2), comprising the steps of:
(a) Arranging the substrate (2) with the surface to be processed in a first plane (23),
(b) Generating multiple laser beams (12) by splitting a single beam of laser light (14) by means of a diffractive optical element (11) such that the multiple laser beams (12) exhibit predetermined constant distances (22) from each other and such that the multiple laser beams (12) are arranged in parallel defining a second plane (15),
(c) Focusing the multiple laser beams (12) by means of a focusing objective (13) onto the substrate (2) for processing parallel grooves (6, 7, 8) in the surface such that the first plane (23) and the second plane (15) form an intersecting line (25) and such that the grooves (6, 7, 8) to be processed in the surface by the individual laser beams incident on the substrate (2) are spaced apart by a pitch (17) from each other with the pitch (17) adjustable by changing the angle (90° - θ) between the desired moving direction (24) and the intersecting line (25), and
(d) Moving the multiple laser beams (12) relative to the substrate (2) in a moving direction (24), whereby
at least the diffractive optical element (11) and the focusing objective (13) are incorporated in a joint housing,
the joint housing comprises a material that is configured for reducing the sensitivity of the joint housing to thermal expansion due to environmental changes,
and
the material comprises fused silica as low expansion material.

12. Method according to the preceding claim 11, whereby the second plane (15) is arranged essentially orthogonal to the first plane (23).

13. Method according to any of the preceding claims 11 or 12, whereby changing the angle (90° - θ) between the moving direction (24) and the intersecting line (25) is being effected by rotating the diffractive optical element (11).

14. Method according to the preceding claim 13, whereby rotating the diffractive optical element (11) is effected by a motion stage (21) allowing for a rotation about an optical axis (16) on which the diffractive optical element (11) and a focusing objective (13) for focusing the multiple laser beams (12) are arranged spaced apart from each other.

15. Method according to any of the preceding claims 13 or 14, whereby the diffractive optical element (11) is rotated in a third plane and the third plane is essentially orthogonal to the incident single laser beam (14) and/or to the second plane (15).

16. Method according to any of the preceding claims 11 to 15, comprising the step of calibrating the angle (90° - θ) between the moving direction (24) and the intersecting line (25).

17. Method according to any of the preceding claims 11 to 16, whereby the angle (90° - θ) is ≥ 0° and ≤ 90° and/or the angle (90° - θ) is configured such that at least two adjacent grooves (6, 7, 8) overlap at least partially.

18. Method according to any of the preceding claims 11 to 17, whereby step (e) is alternatively performed with an angle (90° - θ) configured for creating at least partially overlapping grooves (6, 7, 8).

19. Method according to any of the preceding claims 11 to 18, whereby the diffractive optical element (11) is configured for focusing the multiple laser beams (12) on the substrate (2) thereby achieving a groove positioning accuracy of ≤ 10 µm.

20. Method for manufacturing a thin film solar cell (1) comprising the steps of:
(1) Depositing a thin film material (3, 4, 5) on a substrate (2), and
(2) Laser processing the substrate (2) with a method according to any of the preceding claims 11 to 19, whereby the thin film material (3, 4, 5) comprises the surface to be processed, or
(2') Laser processing the substrate (2) with a laser scribing device according to any of the preceding claims 5 to 10, whereby the thin film material (3, 4, 5) comprises the surface to be processed.

21. Method according to the preceding claim 20, whereby step (2) or step (2') comprises laser processing of at least 20% of the surface area of the substrate (2).

22. Use of a laser scribing device according to any of the preceding claims 4 to 9 for segmenting the substrate (2) into a plurality of segments, comprising a thin film solar cell (1), the thin film solar cell (1) comprises the substrate (2) and a thin film material (3, 4, 5) deposited on the substrate (2) and the thin film material (3, 4, 5) comprises the surface to be processed by the laser scribing device.

## Patentansprüche

1. Laseroptikkopf (10), der zur Verwendung in einer Laserstrukturierungsvorrichtung konfiguriert ist, mit einem diffraktiven optischen Element (11), einem Fokussierobjektiv (13) und einer Einstelleinrichtung (21), wobei
das diffraktive optische Element (11) und das Fokussierobjektiv (13) auf einer gemeinsamen optischen Achse (16) beabstandet voneinander angeordnet sind;
die Einstelleinrichtung (21) dafür konfiguriert ist, das diffraktive optische Element (11) in einer sich orthogonal zur optischen Achse (16) erstreckenden dritten Ebene zu drehen;
mindestens das diffraktive optische Element (11) und das Fokussierobjektiv (13) in einem gemeinsamen Gehäuse aufgenommen sind;
das gemeinsame Gehäuse ein Material aufweist, das dafür konfiguriert ist, die Empfindlichkeit des gemeinsamen Gehäuses auf eine durch Änderungen in der Umgebung verursachte Wärmeausdehnung zu vermindern; und
das Material Quarzglas (Fused Silica) als ein Material mit einer niedrigen Wärmeausdehnung aufweist.

2. Laseroptikkopf (10) nach Anspruch 1, wobei die Einstelleinrichtung (21) einen motorbetriebenen Tisch und/oder einen Schrittmotor zum Drehen des diffraktiven optischen Elements (11) um die optische Achse (16) aufweist.

3. Laseroptikkopf (10) nach einem der vorangehenden Ansprüche, mit einem Steuerteil, wobei das Steuerteil dafür konfiguriert ist, das diffraktive optische Element (11) an einer definierten Winkelposition (θ) der optischen Achse (16) anzuordnen.

4. Laseroptikkopf (10) nach einem der vorangehenden Ansprüche, wobei das diffraktive optische Element (11) und das Fokussierobjektiv (13) in einem Abstand (18) von ≥ 70 mm und ≤ 150 mm, vorzugweise ≥ 25 mm und ≤ 50 mm, voneinander beabstandet sind.

5. Laserstrukturierungsvorrichtung, die zum Laserbearbeiten einer Oberfläche eines Substrats (2) konfiguriert ist, mit einer Positionierungseinrichtung, einem Laseroptikkopf (10) nach einem der vorangehenden Ansprüche und einer Antriebseinrichtung, wobei
die Positionierungseinrichtung dafür konfiguriert ist, das Substrat (2) derart anzuordnen, dass seine zu bearbeitende Oberfläche in einer ersten Ebene (23) liegt,
der Laseroptikkopf (10) dafür konfiguriert ist, durch Teilen eines einfallenden Laserstrahls (14) mehrere Laserstrahlen (12) derart zu erzeugen, dass die mehreren Laserstrahlen (12) vorgegebene Abstände (22) voneinander haben, und derart, dass die mehreren Laserstrahlen (12) parallel angeordnet sind und so eine zweite Ebene (15) definieren,
das Fokussierobjektiv (13) dafür konfiguriert ist, die mehreren Laserstrahlen (12) auf das Substrat (2) zu fokussieren, um parallele Nuten (6, 7, 8) in der Oberfläche derart auszubilden, dass die erste Ebene (23) und die zweite Ebene (15) eine Schnittlinie (25) bilden, und derart, dass die Nuten (6, 7, 8), die durch die auf das Substrat (2) auftreffenden einzelnen Laserstrahlen in der Oberfläche ausgebildet werden, in einem Intervall (17) voneinander beabstandet sind, und
die Antriebseinrichtung dafür konfiguriert ist, den Laseroptikkopf (10) in einer Bewegungsrichtung (24) relativ zum Substrat (2) zu bewegen.

6. Laserstrukturierungsvorrichtung nach Anspruch 5, wobei die Einstelleinrichtung dafür konfiguriert ist, das Intervall (17) der Nuten (6, 7, 8) durch Ändern des Winkels (90° - θ) zwischen der Bewegungsrichtung (24) und der Schnittlinie (25) einzustellen.

7. Laserstrukturierungsvorrichtung nach Anspruch 5 oder 6, wobei der Winkel (θ) ≥ 0° und ≤ 90° ist, und/oder der Winkel (0) derart konfiguriert ist, dass mindestens zwei benachbarte Nuten (6, 7, 8) sich mindestens teilweise überlappen.

8. Laserstrukturierungsvorrichtung nach einem der Ansprüche 5 bis 7, wobei die zweite Ebene (15) im Wesentlichen orthogonal zur ersten Ebene (23) angeordnet ist, und/oder die optische Achse (16) im Wesentlichen orthogonal zur ersten Ebene (23) angeordnet ist.

9. Laserstrukturierungsvorrichtung nach einem der Ansprüche 5 bis 8, wobei der Laseroptikkopf (10) dafür konfiguriert ist, ≥ 2 und ≤ 9 Laserstrahlen (12), vorzugsweise 4 Laserstrahlen (12), zu erzeugen.

10. Laserstrukturierungsvorrichtung nach einem der Ansprüche 5 bis 9, wobei die mehreren Laserstrahlen (12) dafür konfiguriert sind, Nuten (6, 7, 8) in einem auf der Oberfläche des Substrats (2) aufgebrachten Dünnschichtmaterial auszubilden.

11. Verfahren zum Laserbearbeiten einer Oberfläche eines Substrats (2), mit den Schritten:
(a) Anordnen des Substrats (2) derart, dass die zu bearbeitende Oberfläche in einer ersten Ebene (23) liegt;
(b) Erzeugen mehrerer Laserstrahlen (12) durch Teilen eines einzelnen Laserlichtstrahls (14) durch ein diffraktives optisches Element (11) derart, dass die mehreren Laserstrahlen vorgegebene konstante Abstände (22) voneinander haben, und derart, dass die mehreren Laserstrahlen (12) parallel angeordnet sind und so eine zweite Ebene (15) definieren;
(c) Fokussieren der Laserstrahlen (12) durch ein Fokussierobjektiv (13) auf das Substrat (2) zum Ausbilden paralleler Nuten (6, 7, 8) in der Oberfläche derart, dass die erste Ebene (23) und die zweite Ebene (15) eine Schnittlinie (25) bilden, und derart, dass die durch die auf das Substrat (2) auftreffenden einzelnen Laserstrahlen in der Oberfläche auszubildenden Nuten (6, 7, 8) in einem Intervall (17) voneinander beabstandet sind, wobei das Intervall (17) durch Ändern des Winkel (90° - θ) zwischen der gewünschten Bewegungsrichtung (24) und der Schnittlinie (25) einstellbar ist; und
(d) Bewegen der mehreren Laserstrahlen (12) bezüglich des Substrats (2) in der Bewegungsrichtung (24), wobei
mindestens das diffraktive optische Element (11) und das Fokussierobjektiv (13) in einem gemeinsamen Gehäuse aufgenommen sind,
das gemeinsame Gehäuse ein Material aufweist, das dafür konfiguriert ist, die Empfindlichkeit des gemeinsamen Gehäuses auf eine durch Änderungen in der Umgebung verursachte Wärmeausdehnung zu vermindern; und
das Material Quarzglas (Fused Silica) als Material mit einer niedrigen Wärmeausdehnung aufweist.

12. Verfahren nach Anspruch 11, wobei die zweite Ebene (15) im Wesentlichen orthogonal zur ersten Ebene (23) angeordnet ist.

13. Verfahren nach Anspruch 11 oder 12, wobei das Ändern des Winkels (90° - θ) zwischen der Bewegungsrichtung (24) und der Schnittlinie (25) durch Drehen des diffraktiven optischen Elements (11) bewirkt wird.

14. Verfahren nach Anspruch 13, wobei das Drehen des diffraktiven optischen Elements (11) durch einen motorbetriebenen Tisch (21) bewirkt wird, der eine Drehbewegung um eine optische Achse (16) ausführt, auf der das diffraktive optische Element (11) und ein Fokussierobjektiv (13) zum Fokussieren der mehreren Laserstrahlen (12) beabstandet voneinander angeordnet sind.

15. Verfahren nach Anspruch 13 oder 14, wobei das diffraktive optische Element (11) in einer dritten Ebene gedreht wird und die dritte Ebene im Wesentlichen orthogonal zum einfallenden einzelnen Laserstrahl (14) und/oder zur zweiten Ebene (15) angeordnet ist.

16. Verfahren nach einem der Ansprüche 11 bis 15, mit dem Schritt zum Kalibrieren des Winkel (90° - θ) zwischen der Bewegungsrichtung (24) und der Schnittlinie (25).

17. Verfahren nach einem der Ansprüche 11 bis 16, wobei der Winkel (90° - θ) ≥ 0° und ≤ 90° ist und/oder der Winkel (90° - θ) derart konfiguriert ist, dass mindestens zwei benachbarte Nuten (6, 7, 8) sich mindestens teilweise überlappen.

18. Verfahren nach einem der Ansprüche 11 bis 17, wobei Schritt (e) alternativ mit einem Winkel (90° - θ) ausgeführt wird, der derart konfiguriert ist, dass sich mindestens teilweise überlappende Nuten (6, 7, 8) erzeugt werden.

19. Verfahren nach einem der Ansprüche 11 bis 18, wobei das diffraktive optische Element (11) dafür konfiguriert ist, die mehreren Laserstrahlen (12) derart auf das Substrat (2) zu fokussieren, dass eine Nutenpositionierungsgenauigkeit von ≤ 10 µm erhalten wird.

20. Verfahren zum Herstellen einer Dünnschichtsolarzelle (1) mit den Schritten:
(1) Aufbringen eines Dünnschichtmaterials (3, 4, 5) auf ein Substrat (2); und
(2) Laserbearbeiten des Substrats (2) durch ein Verfahren nach einem der Ansprüche 11 bis 19, wobei das Dünnschichtmaterial (3, 4, 5) die zu bearbeitende Oberfläche aufweist; oder
(2') Laserbearbeiten des Substrats (2) durch eine Laserstrukturierungsvorrichtung nach einem der Ansprüche 5 bis 10, wobei das Dünnschichtmaterial (3, 4. 5) die zu bearbeitende Oberfläche aufweist.

21. Verfahren nach Anspruch 20, wobei Schritt (2) oder Schritt (2') das Laserbearbeiten von mindestens 20% der Oberfläche des Substrats (2) aufweist.

22. Verwendung einer Laserstrukturierungsvorrichtung nach einem der Ansprüche 4 bis 9 zum Segmentieren des Substrats (2) in mehrere Segmente, die eine Dünnschichtsolarzelle (1) aufweisen, wobei die Dünnschichtsolarzelle (1) das Substrat (2) und ein auf das Substrat (2) aufgebrachtes Dünnschichtmaterial (3, 4, 5) aufweist, und wobei das Dünnschichtmaterial (3, 4, 5) die durch die Laserstrukturierungsvorrichtung zu bearbeitende Oberfläche aufweist.

## Revendications

1. Tête d'optique laser (10) configurée pour être utilisée dans un dispositif de traçage au laser, comprenant un élément optique diffractif (11), un objectif de focalisation (13) et un moyen d'ajustement (21), dans laquelle
l'élément optique diffractif (11) et l'objectif de focalisation (13) sont agencés de manière à être espacés l'un de l'autre sur un axe optique (16) commun,
le moyen d'ajustement (21) est configuré pour faire tourner l'élément optique diffractif (11) dans un troisième plan orthogonal à l'axe optique (16),
au moins l'élément optique diffractif (11) et l'objectif de focalisation (13) sont incorporés dans un boîtier commun,
le boîtier commun comprend un matériau configuré pour réduire la sensibilité du boîtier commun à la dilatation thermique due aux changements envïronnementaux, et
le matériau comprend de la silice fondue en tant que matériau à faible dilatation.

2. Tête d'optique laser (10) selon la revendication précédente, dans laquelle le moyen d'ajustement (21) comprend une platine motorisée (21) et/ou un moteur pas à pas pour faire tourner l'élément optique diffractif (11) autour de l'axe optique (16).

3. Tête d'optique laser (10) selon l'une quelconque des revendications précédentes, comprenant un contrôleur et le contrôleur étant configuré pour positionner l'élément optique diffractif (11) sur une position angulaire définie (8) de l'axe optique (16).

4. Tête d'optique laser (10) selon l'une quelconque des revendications précédentes, dans laquelle l'élément optique diffractif (11) et l'objectif de focalisation (13) sont espacés l'un de l'autre (18) ≥ 70 mm et ≤ 150 mm, de préférence ≥ 25 mm et ≤ 50 mm.

5. Dispositif de traçage au laser configuré pour un traitement laser d'une surface d'un substrat (2), comprenant un moyen de positionnement, une tête d'optique laser (10) selon l'une quelconque des revendications précédentes et un moyen de déplacement, dans lequel
le moyen de positionnement est configuré pour arranger le substrat (2) avec la surface à traiter dans un premier plan (23),
la tête d'optique laser (10) est configurée pour générer une multitude de faisceaux laser (12) en divisant un faisceau laser incident (14) de manière à ce que la multitude de faisceaux laser (12) présentent des distances constantes prédéterminées (22) les uns par rapport aux autres, et de manière à ce que la multitude de faisceaux laser (12) soient agencés en parallèle, définissant un deuxième plan (15),
l'objectif de focalisation (13) est configuré pour focaliser la multitude de faisceaux laser (12) sur le substrat (2) pour réaliser des rainures parallèles (6, 7, 8) dans la surface, de manière à ce que le premier plan (23) et le deuxième plan (15) forment une ligne d'intersection (25) et de manière à ce que les rainures (6, 7, 8) réalisées dans la surface par les faisceaux laser individuels tombant sur la substrat (2) soient espacées selon un pas (17) les unes des autres, et
le moyen de déplacement est configuré pour déplacer la tête d'optique laser (10) par rapport au substrat (2) dans une direction de déplacement (24).

6. Dispositif de traçage au laser selon la revendication précédente 5, dans lequel le moyen d'ajustement est configuré pour ajuster le pas (17) des rainures (6, 7, 8) en modifiant l'angle (90° - θ) entre la direction de déplacement (24) et la ligne d'intersection (25).

7. Dispositif de traçage au laser selon l'une quelconque des revendications précédentes 5 ou 6, dans lequel l'angle (θ) est ≥ 0° et ≤ 90°, et/ou l'angle (θ) est configuré de manière à ce qu'au moins deux rainures adjacentes (6, 7, 8) se chevauchent au moins partiellement.

8. Dispositif de traçage au laser selon l'une quelconque des revendications précédentes 5 à 7, dans lequel le deuxième plan (15) est agencé essentiellement orthogonalement au premier plan (23) et/ou l'axe optique (16) est agencé essentiellement orthogonalement au premier plan (23).

9. Dispositif de traçage au laser selon l'une quelconque des revendications précédentes 5 à 8, dans lequel la tête d'optique laser (10) est configurée pour générer ≥ 3 et ≤ 9 faisceaux laser (12), de préférence 4 faisceaux laser (12).

10. Dispositif de traçage au laser selon l'une quelconque des revendications précédentes 5 à 9, dans lequel la multitude de faisceaux laser (12) est configurée pour réaliser des rainures (6, 7, 8) dans un film fin de matériau déposé sur la surface (2).

11. Procédé pour le traitement laser d'une surface d'un substrat (2), comprenant les étapes suivantes :
(a) agencement du substrat (2) avec la surface à traiter dans un premier plan (23),
(b) génération d'une multitude de faisceaux laser (12) en divisant un faisceau unique de lumière laser (14) au moyen d'un élément optique diffractif (11) de manière à ce que la multitude de faisceaux laser (12) présentent des distances constantes prédéterminées (22) les uns par rapport aux autres, et de manière à ce que la multitude de faisceaux laser (12) soient agencés en parallèle, définissant un deuxième plan (15),
(c) focalisation de la multitude de faisceaux laser (12) sur le substrat (2) au moyen d'un objectif de focalisation (13) pour réaliser des rainures parallèles (6, 7, 8) dans la surface, de manière à ce que le premier plan (23) et le deuxième plan (15) forment une ligne d'intersection (25) et de manière à ce que les rainures (6, 7, 8) à réaliser dans la surface par les faisceaux laser individuels tombant sur la substrat (2) soient espacées selon un pas (17) les unes des autres, le pas (17) pouvant être ajusté en modifiant l'angle (90° - θ) entre la direction de déplacement souhaitée (24) et la ligne d'intersection (25), et
(d) déplacement de la multitude de faisceaux laser (12) par rapport au substrat (2) dans une direction de déplacement (24), dans lequel au moins l'élément optique diffractif (11) et l'objectif de focalisation (13) sont incorporés dans un boîtier commun,
le boîtier commun comprend un matériau configuré pour réduire la sensibilité du boîtier commun à la dilatation thermique due aux changements environnementaux, et
le matériau comprend de la silice fondue en tant que matériau à faible dilatation.

12. Procédé selon la revendication précédente 11, dans lequel le deuxième plan (15) est agencé essentiellement orthogonalement au premier plan (23).

13. Procédé selon l'une quelconque des revendications précédentes 11 ou 12, dans lequel la variation de l'angle (90° - θ) entre la direction de déplacement (24) et la ligne d'intersection (25) est ajustée en faisant tourner l'élément optique diffractif (11).

14. Procédé selon la revendication précédente 13, dans lequel la rotation de l'élément optique diffractif (11) est réalisée par une platine de mouvement (21) permettant une rotation autour d'un axe optique (16) sur lequel sont agencés l'élément optique diffractif (11) et un objectif de focalisation (13) pour la focalisation de la multitude de faisceaux laser (12), de manière à être espacés l'un de l'autre.

15. Procédé selon l'une quelconque des revendications précédentes 13 ou 14, dans lequel l'élément optique diffractif (11) tourne dans un troisième plan et le troisième plan est essentiellement orthogonal au faisceau laser unique incident (14) et/ou au deuxième plan (15).

16. Procédé selon l'une quelconque des revendications précédentes 11 à 15, comprenant l'étape d'ajustement de l'angle (90° - θ) entre la direction de déplacement (24) et la ligne d'intersection (25).

17. Procédé selon l'une quelconque des revendications précédentes 11 à 16, dans lequel l'angle (90° - θ) est ≥ 0° et ≤ 90°, et/ou l'angle (90° - θ) est configuré de manière à ce qu'au moins deux rainures (6, 7, 8) se chevauchent au moins partiellement.

18. Procédé selon l'une quelconque des revendications précédentes 11 à 17, dans lequel l'étape (e) est alternativement exécutée avec un angle (90° - θ) configuré pour créer des rainures (6, 7, 8) au moins partiellement superposées.

19. Procédé selon l'une quelconque des revendications précédentes 11 à 18, dans lequel l'élément optique diffractif (11) est configuré pour focaliser la multitude de faisceaux laser (12) sur le substrat (2), atteignant ainsi une précision de positionnement de rainure ≤ 10 µm.

20. Procédé pour la fabrication d'une cellule solaire à film fin (1) comprenant les étapes suivantes :
(1) dépôt d'un fin film de matériau (3, 4, 5) sur un substrat (2), et
(2) traitement laser du substrat (2) avec un procédé selon l'une quelconque des revendications précédentes 11 à 19, dans lequel le fin film de matériau (3, 4, 5) comprend la surface à traiter, ou
(2') traitement laser du substrat (2) avec un dispositif de traçage au laser selon l'une quelconque des revendications précédentes 5 à 10, dans lequel le fin film de matériau (3, 4, 5) comprend la surface à traiter.

21. Procédé selon la revendication précédente 20, dans lequel l'étape (2) ou l'étape (2') comprend le traitement laser d'au moins 20% de l'aire de surface du substrat (2).

22. Utilisation d'un dispositif de traçage au laser selon l'une quelconque des revendications précédentes 4 à 9, pour la segmentation du substrat (2) en une pluralité de segments, comprenant une cellule solaire à film fin (1), la cellule solaire (1) comprend le substrat (2) et un fin film de matériau (3, 4, 5) déposé sur la substrat (2), et le fin film de matériau (3, 4, 5) comprend la surface à traiter à l'aide du dispositif de traçage au laser.
